(19) Europäisches Patentamt / European Patent Office / Office européen des brevets

(11) **EP 2 110 954 B1**

(12) **EUROPÄISCHE PATENTSCHRIFT**

(45) Veröffentlichungstag und Bekanntmachung des Hinweises auf die Patenterteilung:
**01.08.2012 Patentblatt 2012/31**

(51) Int Cl.:
*H03F 3/24* (2006.01)     *H03F 3/72* (2006.01)

(21) Anmeldenummer: **09004816.6**

(22) Anmeldetag: **01.04.2009**

(54) **Sendeschaltung, Verfahren zum Senden und Verwendung**

Transmission switch, transmission method and use

Circuit émetteur, procédé d'émission et d'utilisation

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **14.04.2008 DE 102008018914**

(43) Veröffentlichungstag der Anmeldung:
**21.10.2009 Patentblatt 2009/43**

(73) Patentinhaber: **Atmel Automotive GmbH 74072 Heilbronn (DE)**

(72) Erfinder:
• **Ferchland, Tilo, Dipl.-Ing.
01277 Dresden (DE)**
• **Beyer, Sascha, Dipl.-Ing.
01458 Ottendorf-Okrilla (DE)**
• **Kluge, Wolfram, Dr.-Ing.
01109 Dresden (DE)**

(74) Vertreter: **Grünecker, Kinkeldey, Stockmair & Schwanhäusser
Leopoldstrasse 4
80802 München (DE)**

(56) Entgegenhaltungen:
EP-A2- 0 688 109     US-A- 5 548 616
US-A1- 2005 018 780     US-B1- 6 983 135

**Beschreibung**

Die vorliegende Erfindung betrifft eine Sendeschaltung eines Funknetzes, ein Verfahren zum Senden eines Signals und eine Verwendung.

Sendeschaltungen von Funknetzen ermöglichen das Senden von Daten über eine Antenne eines Knotens des Funknetzes. Zur Einstellung der Sendereichweite ist die Sendeleistung des Knotens einstellbar. Beispiele für Funknetze sind beispielsweise in den Industrie-Standards IEEE 802.11, IEEE 802.15.1 oder IEEE 802.15.4 beschrieben.

Aus der Druckschrift EP 0 688 109 A2 ist ein gepulster Transmitter für ein Funknetzwerk bekannt, bei dem die Ausgangsleistung mit Hilfe verschiedener Steuersignale regelbar ist. Ein erstes Steuersignal dient dabei zum Ein- und Ausschalten des gepulsten Transmitters, wobei die Hüllkurve der Ausgangsleistung mittels einer Rückkopplungsschleife durch ein zweites Steuersignal geregelt wird. Mit einem dritten Steuersignal kann bei Verwendung einer Amplitudenmodulation die Rückkopplungsschleife während der Datenübertragung unterbrochen werden.

Aus der Druckschrift US 6,983,135 B1 ist ebenfalls ein Transceiver für ein Funknetzwerk bekannt, bei dem der Verstärkungsfaktor eines Radiofrequenzmischers mit Hilfe eines Referenzsignals kalibriert wird.

Der Erfindung liegt die Aufgabe zugrunde, ein möglichst verbessertes Verfahren zum Senden anzugeben.

Diese Aufgabe wird durch das Verfahren mit den Merkmalen des unabhängigen Anspruchs 1 gelöst. Vorteilhafte Weiterbildungen sind Gegenstand von abhängigen Ansprüchen und in der Beschreibung enthalten.

Demzufolge ist ein Verfahren zum Senden in einem Funknetz vorgesehen. Ein Leistungsverstärker ist dabei mit einer Antenne verbindbar. In dem Verfahren wird der Leistungsverstärker mit einem einer kleinsten Verstärkung des Leistungsverstärkers zugeordneten Zählwert gesteuert.

Hierzu kann beispielsweise ein Zählwert als Bitwert an einen x-Bit-breiten Steuereingang angelegt werden.

Danach wird die Verstärkung schrittweise durch Zählen solange erhöht bis der Zählwert einem in einem Register gespeicherten Registerwert entspricht.

Hierzu wird beispielsweise ein Taktsignal an einen binären Zähler angelegt.

Zur Erhöhung der Verstärkung des Leistungsverstärkers wird entsprechend der Ausbildung des Zählers und des Aufbaus des Leistungsverstärkers entweder heraufgezählt oder heruntergezählt.

Nachdem der Zählwert dem Registerwert entspricht, werden Daten durch ein mittels des Leistungsverstärkers verstärktes Sendesignal übertragen. Das Sendesignal wird hierzu beispielsweise durch eine bestimmte Modulation in Abhängigkeit von den Daten erzeugt.

Nach dem Übertragen der Daten wird die Verstärkung schrittweise durch Zählen solange verringert bis der der kleinsten Verstärkung des Leistungsverstärkers zugeordnete Zählwert erreicht wird. Zur Verringerung der Verstärkung des Leistungsverstärkers wird entsprechend der Ausbildung des Zählers und des Aufbaus des Leistungsverstärkers heruntergezählt beziehungsweise heraufgezählt. Heruntergezählt wird beispielsweise, wenn der kleinsten Verstärkung beispielsweise der Zählwert 0000 zugeordnet ist. Heraufgezählt wird beispielsweise, wenn der kleinsten Verstärkung beispielsweise der Zählwert 1111 zugeordnet ist.

Der Erfindung liegt weiterhin die Aufgabe zugrunde, eine Sendeschaltung möglichst zu verbessern.

Diese Aufgabe wird durch eine Sendeschaltung mit den Merkmalen des Anspruchs 4 gelöst. Vorteilhafte Weiterbildungen sind Gegenstand von abhängigen Ansprüchen und in der Beschreibung enthalten.

Demzufolge ist eine Sendeschaltung eines Funknetzes vorgesehen. Die Sendeschaltung weist einen Leistungsverstärker auf, der mit einer Antenne verbindbar ist. Vorzugsweise weist die Sendeschaltung für die Verbindung einen Leistungsausgang auf. Zudem weist die Sendeschaltung einem Zähler auf, dessen Ausgang mit einem Steuereingang des Leistungsverstärkers zur Ausgabe eines Zählwerts zur Steuerung der Verstärkung des Leistungsverstärkers verbunden ist. Der Ausgang des Zählers und der Steuereingang des Leistungsverstärkers weisen hierzu vorzugsweise eine korrespondierende Bitbreite von beispielsweise vier Bit auf. Der Leistungsverstärker weist einen Signaleingang auf und ist zur Verstärkung eines am Signaleingang anliegenden zu verstärkenden Signals in Abhängigkeit von einem Steuersignal am Steuereingang ausgebildet.

Die Sendeschaltung weist ein Register zur Speicherung eines Registerwerts auf. Vorzugsweise weist das Register zumindest eine Bitbreite auf, die größer oder gleich der Bitbreite des Ausgangs des Zählers ist.

Die Sendeschaltung weist einen Vergleicher auf, dessen Eingänge mit dem Ausgang des Zählers und dem Register zum Vergleich des Registerwerts mit dem Zählwert verbunden sind.

Die Sendeschaltung weist eine Kontrollschaltung auf, deren Eingang mit dem Vergleicher und deren Ausgang mit dem Zähler zur Steuerung eines Zählvorgangs in Abhängigkeit vom Vergleichsergebnis des Vergleichers verbunden sind.

Vorzugsweise ist die Sendeschaltung zur Durchführung des zuvor erläuterten Verfahrens ausgebildet und eingerichtet.

Der Erfindung liegt weiterhin die Aufgabe zugrunde, eine Verwendung anzugeben.

Diese Aufgabe wird durch eine Verwendung mit den Merkmalen des unabhängigen Anspruchs 15 gelöst. Vorteilhafte Weiterbildungen sind Gegenstand von abhängigen Ansprüchen und in der Beschreibung angegeben.

Demzufolge ist eine Verwendung eines Zählers und eines Registers und eines Vergleichers vorgesehen. Der Zähler, das Register und der Vergleicher werden verwendet zum stufenförmigen Erhöhen einer Verstärkung eines Leistungsverstärkers eines Funknetzes vor dem Senden von Daten ausgehend von einer kleinsten Verstärkung durch Zählen mittels des Zählers bis ein Zählwert des Zählers einen im Register gespeicherten Registerwert erreicht und zum stufenförmigen Vermindern der Verstärkung des Leistungsverstärkers nach dem Senden der Daten durch Zählen mittels des Zählers bis ein der kleinsten Verstärkung des Leistungsverstärkers zugeordneter Zählwert erreicht wird.

Die im Folgenden beschriebenen Weiterbildungen beziehen sich sowohl auf die Sendeschaltung als auch auf das Verfahren als auch auf die Verwendung. Dementsprechend ist die Sendeschaltung vorzugsweise zur Durchführung der Verfahrensschritte ausgebildet und eingerichtet.

Gemäß einer vorteilhaften Weiterbildung wird nach einem Einschalten des Leistungsverstärkers vor der schrittweisen Erhöhung der Verstärkung ein Signaleingang des Leistungsverstärkers mit einem Ausgang eines Treibers verbunden. Bevorzugt wird zur Verbindung des Signaleingangs des Leistungsverstärkers mit dem Ausgang des Treibers eine Dämpfung kontinuierlich verringert.

In einer bevorzugten Weiterbildung weist die Sendeschaltung ein steuerbares Dämpfungsglied auf, das zur Verbindung, insbesondere zur kontinuierlichen Dämpfung ausgebildet ist. Vorzugsweise ist ein Signaleingang des Leistungsverstärkers über ein steuerbares Dämpfungsglied mit einem Ausgang eines Treibers verbunden.

Vorzugsweise weist das Dämpfungsglied einen steuerbaren Widerstand auf. Vorteilhafterweise weist das Dämpfungsglied einen Feldeffekttransistor auf.

Gemäß einer vorteilhaften Ausgestaltung ist das Dämpfungsglied zur kontinuierlichen Veränderung einer Dämpfung ausgebildet und zur Steuerung der Dämpfung mit der Kontrollschaltung verbunden.

In einer anderen Weiterbildung ist vorgesehen, dass die Kontrollschaltung zur Steuerung einer Zählrichtung eingerichtet und mit dem Zähler zur Steuerung der Zählrichtung verbunden ist.

Gemäß einer besonders bevorzugten Weiterbildung ist vorgesehen, dass das Register derart ausgebildet und verbunden ist, dass der Registerwert programmierbar ist. Hierzu weist die Sendeschaltung eine Verbindung mit dem Register, vorteilhafterweise eine Schnittstelle auf.

Die zuvor beschriebenen Weiterbildungsvarianten sind sowohl einzeln als auch in Kombination besonders vorteilhaft. Dabei können sämtliche Weiterbildungsvarianten untereinander kombiniert werden. Einige mögliche Kombinationen sind in der Beschreibung jedes Ausführungsbeispiels der Figuren näher erläutert. Die dort dargestellten Möglichkeiten von Kombinationen der Weiterbildungsvarianten sind jedoch nicht abschließend.

Im Folgenden wird die Erfindung durch Ausführungsbeispiele anhand zeichnerischer Darstellungen näher erläutert.

Dabei zeigen

Fig. 1    einen schematischen Blockschaltplan einer Sendeschaltung;

Fig. 2    einen schematischen Schaltplan eines Leistungsverstärkers; und

Fig. 3    ein schematisches Ablaufdiagramm eines Verfahrens.

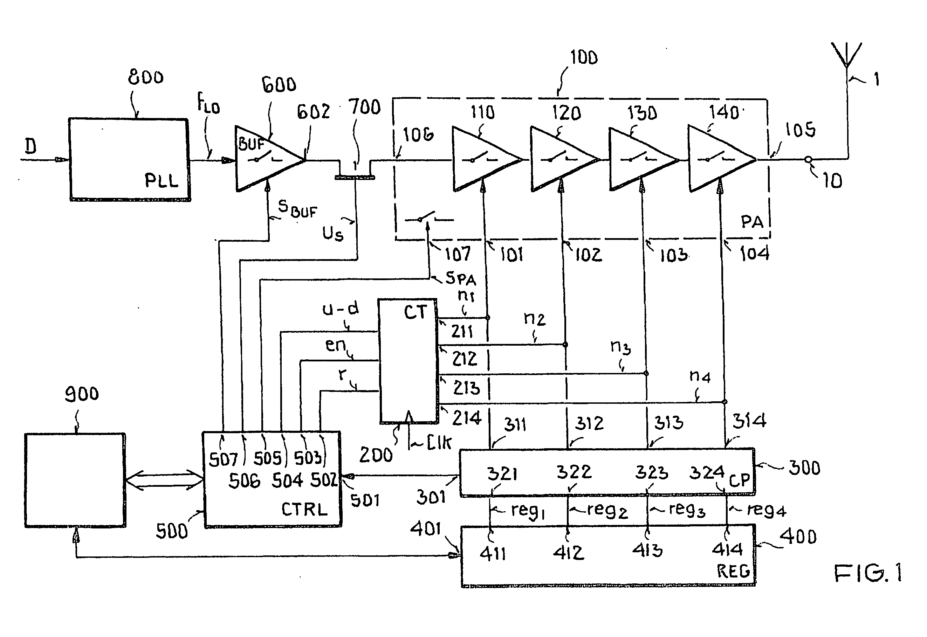

Fig. 1 zeigt einen schematischen Blockschaltplan einer Sendeschaltung eines Knotens eines Funknetzes. Die Sendeschaltung weist einen Leistungsverstärker (PA - engl. Power Amplifier) 100 auf, dessen Leistungsausgang 105 mit einem Ausgang 10 der Sendeschaltung verbunden ist. An dem Ausgang 10 der Sendeschaltung, der beispielsweise als Pad ausgebildet sein kann, ist eine Antenne 1 anschließbar. Dabei ist die Antenne 1 nicht unbedingt Bestandteil der Sendeschaltung.

Der Leistungsverstärker 100 ist zur Verstärkung des zu sendenden Signals ausgebildet. Zur Einstellung der Verstärkung weist der Leistungsverstärker mehrere steuerbare Teilverstärker 110, 120, 130, 140 mit zugehörigen Steuerleitungen 101, 102, 103 respektive 104 auf. Die steuerbaren Teilverstärker 110, 120, 130, 140 sind beispielsweise für eine lineare, stufenförmige Verstärkungseinstellung ausgebildet. Alternativ kann auch eine nichtlineare, beispielsweise logarithmische Verstärkungseinstellung vorgesehen sein. Weiterhin weist der Leistungsverstärker 100 noch einen weiteren Steuereingang 107 zur Einschaltung beziehungsweise Abschaltung der Verstärkung des Leistungsverstärkers 100 auf.

Im Ausführungsbeispiel der Fig. 1 ist ein Signaleingang 106 des Leistungsverstärkers 100 über ein steuerbares Dämpfungsglied 700 mit dem Ausgang 602 eines schaltbaren Treibers (BUF - engl. Buffer) 600 verbunden. Der Eingang des Treibers 600 ist mit einem Modulator 800 verbunden, der im Ausführungsbeispiel der Fig. 1 als PLL (engl. Phase Locked Loop) ausgebildet ist. Im Sendebetrieb werden Daten D vom Modulator 800 moduliert und gelangen als moduliertes, zu sendendes Signal über den Treiber 600 und über das auf geringste Dämpfung eingestellte Dämpfungsglied 700 zum Eingang 106 des Leistungsverstärkers 100, werden im Leistungsverstärker 100 verstärkt und zur Antenne 1 ausgegeben.

Die Sendeschaltung des Ausführungsbeispiels der Fig. 1 weist einen Zähler (CT - engl. Counter) 200 auf, dessen Ausgangsleitungen 211, 212, 213, 214 mit den Steuerleitungen 101, 102, 103 respektive 104 des Leistungsverstärkers 100 verbunden sind. An einen Takteingang des Zählers 200 ist ein Taktsignal clk angelegt. Durch die Verbindung des Ausgangs des Zählers 200 mit dem Steuereingang des Leistungsverstärkers 100 kann die Verstärkung durch Zählen verändert werden. Weiterhin sind die Ausgangsleitungen 211, 212, 213, 214 mit Eingangsleitungen 311, 312, 313, 314 eines Vergleichers (CP) 300 verbunden. Weitere Eingangsleitungen 321, 322, 323, 324 des Vergleichers 300 sind mit Ausgangsleitungen 411, 412, 413, 414 eines Registers (REG) 400 verbunden. Der Vergleicher 300 ist zum Vergleich eines Zählwertes n des Zählers 300 mit einem Registerwert reg des Registers 400 ausgebildet. Der Zählwert n hat dabei eine Bit-breite von vier Bit n1, n2, n3 und n4. Ebenfalls hat das Register eine Bit-breite von vier Bit reg1, reg2, reg3 und reg4.

Das Vergleichsergebnis wird am Ausgang 301 des Vergleichers 300 ausgegeben und gelangt an einen mit dem Ausgang 301 verbundenen Eingang 501 einer Kontrollschaltung 500. Die Ausgänge 502, 503 und 504 der Kontrollschaltung 500 sind mit dem Zähler 200 zur Steuerung des Zählers 200 verbunden. Am Ausgang 502 kann die Kontrollschaltung 500 ein Rücksetzsignal (engl. reset) r ausgeben um den Zähler 200 zurückzusetzen. Am Ausgang 503 kann die Kontrollschaltung 500 ein Aktivierungs-Signal (engl. enable) en ausgeben um einen Zählvorgang des Zählers 200 zu starten bzw. zu stoppen. Am Ausgang 504 kann die Kontrollschaltung 500 ein Richtungssignal (engl. up-down) u-d ausgeben um eine Zählrichtung des Zählers 200 einzustellen. Weiterhin weist die Kontrollschaltung 500 den Ausgang 505 zum Einschalten und Ausschalten der Verstärkung des Leistungsverstärkers 100 mittels des Steuersignals $S_{PA}$ auf, der mit einem Steuereingang 107 des Leistungsverstärkers 100 verbunden ist. Weiterhin weist die Kontrollschaltung 500 den Ausgang 506 zur Ausgabe der Steuerspannung Us auf, der mit einem Steuereingang (Gate) des als NMOS-Feldeffekttransistor ausgebildeten Dämpfungsglieds 700 zur Einstellung der Dämpfung verbunden ist. Weiterhin weist die Kontrollschaltung 500 den Ausgang 507 zum Einschalten und Ausschalten des Treibers 600 mittels des Steuersignals $S_{BUF}$ auf, der mit einem Steuereingang des Treibers 600 verbunden ist.

Die Sendeschaltung weist im Ausführungsbeispiel der Fig. 1 eine oder mehrere Schnittstellen zu einer Recheneinheit, beispielsweise einem Mikrocontrollerkern 900 auf. Die Sendeschaltung ist über die Schnittstelle/Eingang 401 des Registers 400 programmierbar, indem der Registerwert reg in das Register 400 über die Schnittstelle 401 schreibbar ist. Zum Programmieren des Registerwerts reg im Register 400 kann zunächst eine benötigte Verstärkung durch Messen einer in einem Empfangsknoten empfangenen Feldstärke ermittelt werden. Nachfolgend wird ein zur benötigten Verstärkung korrespondierender Registerwert reg im Register 400 gespeichert.

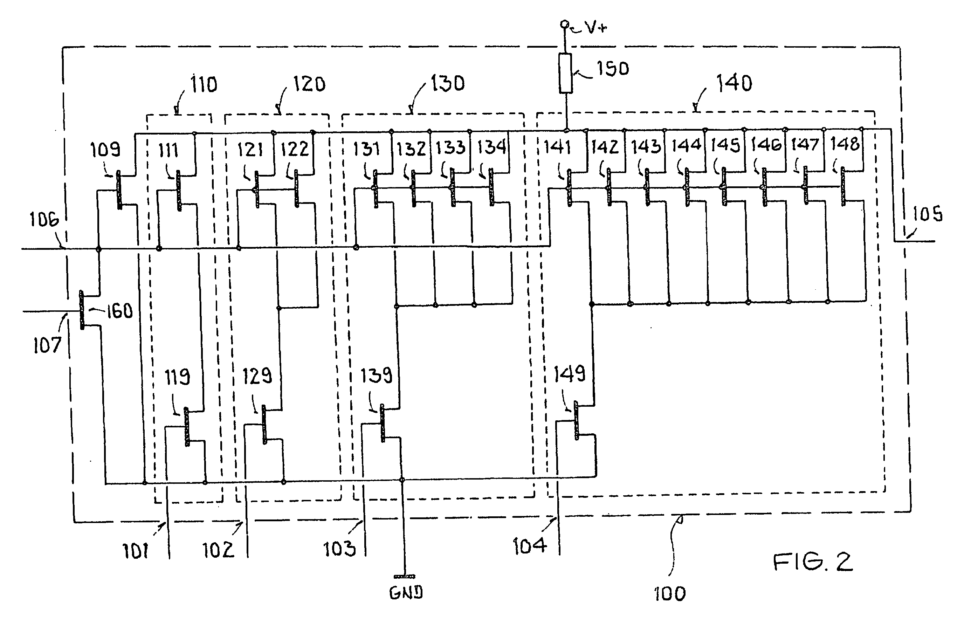

Eine Ausgestaltungsvariante eines Leistungsverstärkers 100 ist als schematischer Schaltplan in Fig. 2 dargestellt. Alle der Verstärkung dienenden Transistoren 109, 111, 121, 122, 131, 132, 133, 134, 141, 142, 143, 144, 145, 146, 147 und 148 sind mit dem Signaleingang 106 und dem Leistungsausgang 105 des Leistungsverstärkers 100 verbunden. Die geringste Verstärkung ist dabei durch den Transistor 109 festgelegt. Dem Teilverstärker 110 ist der Transistor 111 zugeordnet, dessen Source über den Steuertransistor 119 mit Masse GND verbindbar ist. Der Teilverstärker 120 weist zwei Transistoren 121 und 122 zur Verstärkung auf, deren jeweilige Source über den Steuertransistor 129 mit Masse GND verbindbar ist. Der Teilverstärker 130 weist vier Transistoren 131 bis 134 zur Verstärkung auf, deren jeweilige Source über den Steuertransistor 139 mit Masse GND verbindbar ist. Der Teilverstärker 140 weist acht Transistoren 141 und 148 zur Verstärkung auf, deren jeweilige Source über den Steuertransistor 149 mit Masse GND verbindbar ist. Die jeweils zur Verstärkung beitragenden Transistoren 109 bis 148 sind zueinander parallel geschaltet und wirken auf dieselbe Last 150. Die Last 150 ist vorzugsweise als Induktivität ausgebildet. Alternativ kann die Last 150 auch als passiver oder aktiver Widerstand oder als Stromquelle ausgebildet sein. Durch die Anzahl der Transistoren je Teilverstärker wird eine binäre Wichtung erzielt.

Die Steuereingänge der Steuertransistoren 119 bis 149 sind mit den Steuerleitungen 101 bis 104 respektive verbunden. Der Leistungsausgang 105 ist über die Last 150 mit einem positiven Versorgungsspannungsanschluss V+ verbunden. Der Signaleingang 106 kann mittels des Steuertransistors 160 mit Masse GND kurzgeschlossen werden, um die Verstärkung des Leistungsverstärkers 100 abzuschalten.

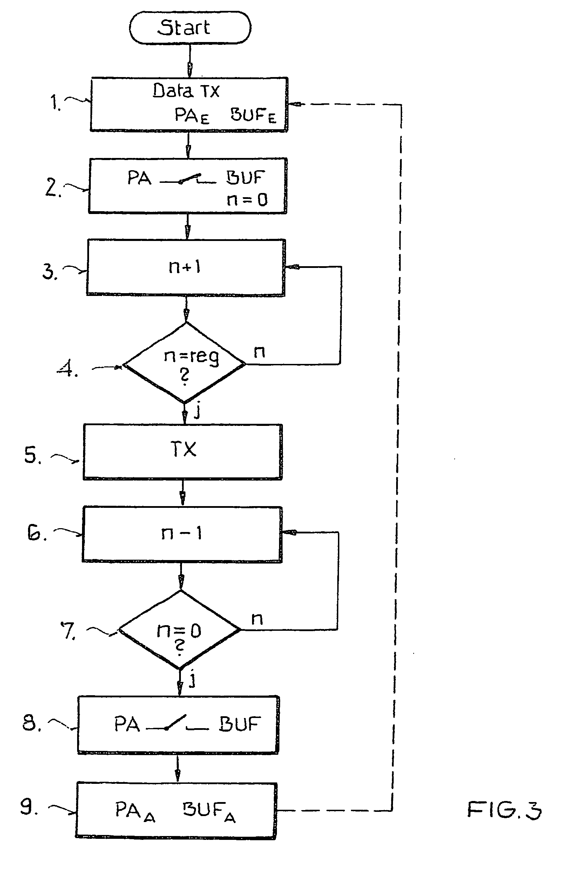

In Fig. 3 zeigt ein Diagramm zur schematischen Darstellung eines Verfahrensablaufs zum Senden in einem Funknetz.

Nach dem Start liegt in einem 1. Verfahrensschritt Daten D zum Senden (TX) vor. Dabei wird der Leistungsverstärker 100 in den Zustand "eingeschaltet" ($PA_E$) und ebenfalls der Treiber 600 in den Zustand "eingeschaltet" ($BUF_E$) versetzt. Im 2. Schritt wird der Leistungsverstärker (PA) 100 mit dem Treiber (BUF) 600 durch kontinuierliche Verringerung der Dämpfung durch das Dämpfungsglied 700 verbunden. Am Eingang des Treibers 600 und damit am Eingang 106 des Leistungsverstärkers 100 liegt während der kontinuierlichen Verringerung der unmodulierte Träger $f_{LO}$ (ohne Daten D) an. Das Trägersignal erscheint mit einer geringen Leistung am Ausgang 10.

Der Leistungsverstärker 100 wird mit einem einer kleinsten Verstärkung des Leistungsverstärkers 100 zuge-

ordnetem Zählwert

$$n = 0 \text{ bzw. } n1|n2|n3|n4 = 0|0|0|0$$

durch den Zähler 200 gesteuert. Hierzu kann die Kontrollschaltung 500 durch das Rücksetzsignal r den Zähler 200 zurücksetzen.

Danach wird die Verstärkung schrittweise durch Zählen erhöht. Im 3. Schritt wird hierzu n um Eins (n + 1) auf n = 1 (0001) durch das Taktsignal clk am Takteingang des Zählers 200 erhöht. Im 4. Schritt wird der Zählwert n mit einem Registerwert reg im Register 400 durch den Vergleicher 300 verglichen. Entspricht der Zählwert n nicht dem Registerwert reg wird erneut im 3. Schritt der Zählwert n um eins erhöht. Entspricht der Zählwert n dem Registerwert reg erfolgt im 5. Schritt eine Übertragung (TX) von Daten D, die mittels eines vom Leistungsverstärker 100 verstärkten Sendesignals übertragen werden.

Nach dem Übertragen der Daten D wird im 6. Schritt der Zählwert n durch Rückwärtszählen um Eins verringert (n - 1). Somit wird die Verstärkung schrittweise durch Zählen solange verringert, bis der der kleinsten Verstärkung des Leistungsverstärkers 100 zugeordnete Zählwert n = 0 im 7. Schritt erreicht wird. Darauf folgend wird im 8. Schritt die Signalverbindung zwischen Leistungsverstärker (PA) 100 und Treiber (BUF) 600 nach kontinuierlicher Erhöhung der Dämpfung durch das Dämpfungsglied 700 unterbrochen. Danach werden der Leistungsverstärker 100 und der Treiber 600 in den "abgeschalteten" Zustand (PA$_A$, BUF$_A$) versetzt. Hierzu wird der Signaleingang 106 durch Öffnen des Transistors 160 mit Masse GND kurzgeschlossen. Sollen weitere Daten D gesendet werden, kann das Verfahren im 1. Schritt fortgesetzt werden.

Die Erfindung ist nicht auf die dargestellten Ausgestaltungsvarianten der Figuren beschränkt. Beispielsweise ist es möglich anstelle der NMOS-Feldeffektransistoren des Leistungsverstärkers 100 in Fig. 2 eine komplementäre Schaltung mit PMOS-Feldeffektransistoren zu verwenden. Auch ist es möglich NMOS-Feldeffektransistoren und PMOS-Feldeffektransistoren zu verschalten und den Leistungsverstärker als Push-Pull-Stufe auszubilden. Die Funktionalität der Sendeschaitung gemäß dem Ausführungsbeispiel der Fig. 1 und des Ablaufdiagramms gemäß dem Ausführungsbeispiel der Fig. 3 wird besonders vorteilhaft für ein Funknetz des Industrie-Standards IEEE 802.15.4 verwendet.

Bezugszeichenliste

| | |
|---|---|
| 1 | Antenne |
| 10 | Ausgang, Pad |
| 100, PA | Leistungsverstärker |
| 101, 102, 103, 104, 107 | Steuereingang |
| 105 | Leistungsausgang |
| 106 | Signaleingang |
| 110, 120, 130, 140 | Teilverstärker |
| 109, 111, 119, 121, 122, 129, 131, 132, 133, 134, 139, 141, 142, 143, 144, | NMOS-Feldeffekttransistor |
| 145, 146, 147, 148, 149, 160 150 | Last, Induktivität, Widerstand |
| 200, CT | Zähler |
| 211, 212, 213, 214, 301, 411, 412, 413, 414, 502, 503, 504, 505, 506, 507, 602 300, CP | Ausgang<br>Vergleicher |
| 311, 312, 313, 314, 321, 322, 323, 324,401,501 400, REG | Eingang<br>Register |
| 500, CTRL | Kontrollschaltung |
| 600, BUF | Treiber |
| 700 | Dämpfungsglied, NMOS-Transistor |
| 800, PLL | Modulator |
| 900 | Recheneinheit, Mikrocontrollerkern |
| GND | Masse |
| V+ | Versorgungsspannungsanschluss |
| clk | Taktsignal |
| D | Daten |

| | |
|---|---|
| $f_{LO}$ | Trägersignal |
| n, n1, n2, n3, n4 | Zählwert |
| reg, reg1, reg2, reg3, reg4 | Registerwert |
| $S_{PA}$, $S_{BUF}$, $U_S$, u-d, en, r | Steuersignal |

**Patentansprüche**

1. Verfahren zum Senden in einem Funknetz,

   - bei dem ein mit einer Antenne (1) verbindbarer Leistungsverstärker (100) mit einem einer kleinsten Verstärkung des Leistungsverstärkers (100) zugeordnetem Zählwert (n = 0) gesteuert wird,
   - bei dem danach die Verstärkung schrittweise durch Zählen solange erhöht wird bis der Zählwert (n) einem in einem Register (400) gespeicherten Registerwert (reg) entspricht,
   - bei dem danach Daten (D) durch ein mittels des Leistungsverstärkers (100) verstärktes Sendesignal übertragen werden, und
   - bei dem nach dem Übertragen der Daten (D) die Verstärkung schrittweise durch Zählen solange verringert wird bis der der kleinsten Verstärkung des Leistungsverstärkers (100) zugeordnete Zählwert (n = 0) erreicht wird.

2. Verfahren nach Anspruch 1, bei dem nach einem Einschalten des Leistungsverstärkers (100) vor der schrittweisen Erhöhung der Verstärkung ein Signaleingang (106) des Leistungsverstärkers (100) mit einem Ausgang (602) eines Treibers (600) verbunden wird.

3. Verfahren nach Anspruch 2, bei dem zur Verbindung des Signaleingangs (106) des Leistungsverstärkers (100) mit dem Ausgang (602) des Treibers (600) eine Dämpfung kontinuierlich verringert wird.

4. Sendeschaltung eines Funknetzes

   - mit einem Leistungsverstärker (100), der mit einer Antenne (1) verbindbar ist,
   - mit einem Zähler (200), dessen Ausgang (211, 212, 213, 214) mit einem Steuereingang (101, 102, 103, 104) des Leistungsverstärkers (100) zur Ausgabe eines Zählwerts (n) zur Steuerung der Verstärkung des Leistungsverstärkers (100) verbunden ist,
   - mit einem Register (400) zur Speicherung eines Registerwerts (reg),
   - mit einem Vergleicher (300), dessen Eingänge (311, 312, 313, 314, 321, 322, 323, 324) mit dem Ausgang (211, 212, 213, 214) des Zählers (200) und dem Register (400) zum Vergleich des Registerwerts (reg) mit dem Zählwert (n) verbunden sind,
   - mit einer Kontrollschaltung (500), deren Eingang (501) mit dem Vergleicher (300) und deren Ausgang (502, 503, 504) mit dem Zähler (200) zur Steuerung eines Zählvorgangs in Abhängigkeit vom Vergleichsergebnis des Vergleichers (300) verbunden sind.

5. Sendeschaltung nach Anspruch 4, bei der die Kontrollschaltung (500) zur Steuerung einer Zählrichtung (u-d) eingerichtet und mit dem Zähler (200) verbunden ist.

6. Sendeschaltung nach einem der vorhergehenden Ansprüche, bei der ein Signaleingang (106) des Leistungsverstärkers (100) über ein steuerbares Dämpfungsglied (700) mit einem Ausgang (602) eines Treibers (600) verbunden ist.

7. Sendeschaltung nach Anspruch 6, bei der das Dämpfungsglied (700) zur kontinuierlichen Veränderung einer Dämpfung ausgebildet und zur Steuerung der Dämpfung mit der Kontrollschaltung (500) verbunden ist.

8. Sendeschaltung nach einem der Ansprüche 4 bis 7, bei der der Registerwert (reg) programmierbar ist.

9. Verwendung eines Zählers (200) und eines Registers (400) und eines Vergleichers (300) zum stufenförmigen Erhöhen einer Verstärkung eines Leistungsverstärkers (100) eines Funknetzes vor dem Senden von Daten (D) ausgehend von einer kleinsten Verstärkung durch Zählen mittels des Zählers (200) bis ein Zählwert (n) des Zählers (200) einen im Register (400) gespeicherten Registerwert (reg) erreicht
   und zum stufenförmigen Vermindern der Verstärkung des Leistungsverstärkers (100) nach dem Senden der Daten durch Zählen mittels des Zählers (200) bis ein der kleinsten Verstärkung des Leistungsverstärkers (100) zugeordneter Zählwert (n = 0) erreicht wird.

**Claims**

1. Method of transmitting in a radio network,

   - whereby a power amplifier (100) connectable to an antenna (1) is controlled on the basis of a count value (n = 0) assigned to a smallest amplification of the power amplifier (100),
   - whereby the amplification is then increased in steps by counting until the count value (n) corresponds to a register value (reg) stored in a register (400),
   - whereby data (D) is then transmitted by means of a transmit signal amplified by means of the power amplifier (100), and
   - whereby, once the data (D) has been transmitted, the amplification is reduced in steps by counting until the count value (n = 0) assigned to the smallest amplification of the power amplifier (100) is reached.

2. Method as claimed in claim 1, whereby, after switching on the power amplifier (100) prior to increasing the amplification in steps, a signal input (106) of the power amplifier (100) is connected to an output (602) of a driver (600).

3. Method as claimed in claim 2, whereby an attenuation is continually reduced in order to connect the signal input (106) of the power amplifier (100) to the output (602) of the driver (600).

4. Transmission circuit of a radio network

   - with a power amplifier (100) connectable to an antenna (1),
   - with a counter (200), the output (211, 212, 213, 214) of which is connected to a control input (101, 102, 103, 104) of the power amplifier (100) in order to output a count value (n) in order to control the amplification of the power amplifier (100),
   - with a register (400) for storing a register value (reg),
   - with a comparator (300), the inputs (311, 312, 313, 314, 321, 322, 323, 324) of which are connected to the output (211, 212, 213, 214) of the counter (200) and to the register (400) in order to compare the register value (reg) with the count value (n),
   - with a control circuit (500), the input (501) of which is connected to the comparator (300) and the output (502, 503, 504) of which is connected to the counter (200) in order to control a counting process as a function of the comparison result of the comparator (300).

5. Transmission circuit as claimed in claim 4, in which the control circuit (500) is configured to control a counting direction (u-d) and is connected to the counter (200).

6. Transmission circuit as claimed in one of the preceding claims, in which a signal input (106) of the power amplifier (100) is connected to an output (602) of a driver (600) via a controllable attenuator (700).

7. Transmission circuit as claimed in claim 6, in which the attenuator (700) is designed to continuously vary an attenuation and is connected to the control circuit (500) in order to control the attenuation.

8. Transmission circuit as claimed in one of claims 4 to 7, in which the register value (reg) is programmable.

9. Use of a counter (200) and a register (400) and a comparator (300) to increase an amplification of a power amplifier (100) of a radio network in steps prior to transmitting data (D) starting from a smallest amplification by counting by means of the counter (200) until a count value (n) of the counter (200) reaches a register value (reg) stored in the register (400),
   and to reduce the amplification of the power amplifier (100) in steps after transmitting the data by counting by means of the counter (200) until a count value (n = 0) assigned to the smallest amplification of the power amplifier (100) is reached.

**Revendications**

1. Procédé pour émettre dans un réseau radio,

   - selon lequel un amplificateur de puissance (100) apte à être relié à une antenne (1) est commandé avec une valeur de comptage (n=0) associée à une amplification minimale de l'amplificateur (100),
   - selon lequel l'amplification est ensuite augmentée progressivement par comptage jusqu'à ce que la valeur de comptage (n) corresponde à une valeur de registre (reg) mise en mémoire dans un registre (400),
   - selon lequel des données (D) sont ensuite transmises par un signal d'émission amplifié à l'aide de l'amplificateur de puissance (100), et
   - selon lequel après la transmission des données (D), l'amplification est réduite progressivement par comptage jusqu'à ce que la valeur de comptage (n=0) associée à l'amplification minimale de l'amplificateur (100) soit atteinte.

2. Procédé selon la revendication 1, selon lequel après la mise en marche de l'amplificateur de puissance (100) et avant l'augmentation progressive de l'amplification, une entrée de signal (106) de l'amplificateur (100) est reliée à une sortie (602) d'un pilote (600).

3. Procédé selon la revendication 2, selon lequel pour la liaison de l'entrée de signal (106) de l'amplificateur de puissance (100) avec la sortie (602) du pilote (600), une atténuation est réduite en continu.

4. Circuit émetteur d'un réseau radio

   - avec un amplificateur de puissance (100) qui est apte à être relié à une antenne (1),
   - avec un compteur (200) dont la sortie (211, 212, 213, 214) est reliée à une entrée de commande (101, 102, 103, 104) de l'amplificateur de puissance (100) en vue d'émettre une valeur de comptage (n) pour commander l'amplification de l'amplificateur de puissance (100),
   - avec un registre (400) pour la mise en mémoire d'une valeur de registre (reg),
   - avec un comparateur (300) dont les entrées (311, 312, 313, 314, 321, 322, 323, 324) sont reliées à la sortie (211, 212, 213, 214) du compteur (200) et au registre (400) en vue de la comparaison de la valeur de registre (reg) avec la valeur de comptage (n),
   - avec un circuit de contrôle (500) dont l'entrée (501) est reliée au comparateur (300) et dont la sortie (502, 503, 504) est reliée au compteur (200) en vue de commander une opération de comptage en fonction du résultat de la comparaison du comparateur (300).

5. Circuit émetteur selon la revendication 4, dans lequel le circuit de contrôle (500) est conçu pour commander un sens de comptage (u-d) et est relié au compteur (200).

6. Circuit émetteur selon l'une des revendications précédentes, dans lequel une entrée de signal (106) de l'amplificateur de puissance (100) est reliée par l'intermédiaire d'un organe d'atténuation apte à être commandé (700) à une sortie (602) d'un pilote (600).

7. Circuit émetteur selon la revendication 6, dans lequel l'organe d'atténuation (700) est conçu pour modifier en continu une atténuation et est relié au circuit de contrôle (500) afin de commander l'atténuation.

8. Circuit émetteur selon l'une des revendications 4 à 7, dans lequel la valeur de registre (reg) est programmable.

9. Utilisation d'un compteur (200) et d'un registre (400) et d'un comparateur (300) pour l'augmentation étagée d'une amplification d'un amplificateur de puissance (100) d'un réseau radio avant l'émission de données (D), à partir d'une amplification minimale, grâce au comptage à l'aide du compteur (200) jusqu'à ce qu'une valeur de comptage (n) du compteur (200) atteigne une valeur de registre (reg) mise en mémoire dans le registre (400), et pour la réduction étagée de l'amplification de l'amplificateur de puissance (100) après l'émission des données, grâce au comptage à l'aide du compteur (200) jusqu'à ce qu'une valeur de comptage (n=0) associée à l'amplification minimale de l'amplificateur de puissance (100) soit atteinte.

FIG.1

FIG.2

FIG.3

**IN DER BESCHREIBUNG AUFGEFÜHRTE DOKUMENTE**

**In der Beschreibung aufgeführte Patentdokumente**

- EP 0688109 A2

- US 6983135 B1